# EUROPEAN PATENT SPECIFICATION

(11) **EP 3 085 493 B1**
(45) Date of publication and mention of the grant of the patent: **03.01.2018**
(21) Application number: 16164390.3
(22) Date of filing: 08.04.2016
(51) Int. Cl.: B24B 37/00, B24B 37/08

(54) **DOUBLE-SIDE POLISHING APPARATUS AND POLISHING METHOD**
DOPPELSEITIGE POLIERVORRICHTUNG UND POLIERVERFAHREN
APPAREIL ET PROCÉDÉ DE POLISSAGE DOUBLE FACE

(30) Priority: 20.04.2015 JP 2015085845
(43) Date of publication of application: 26.10.2016
(73) Proprietor: Fujikoshi Machinery Corporation, Nagano-shi, Nagano 381-1233 (JP)
(72) Inventor: WADA, Masaki, Nagano 381-1233 (JP); AKASHIO, Norihiko, Nagano 381-1233 (JP); YODA, Ryosuke, Nagano 381-1233 (JP)
(74) Representative: Bailey, Sam Rogerson

(56) References cited:
- EP-A1- 1 048 409
- EP-A1- 1 555 089
- EP-A1- 1 795 302
- EP-A2- 1 393 858
- GB-A- 1 454 545
- JP-A- H10 230 452
- US-A- 3 105 328
- US-A- 4 157 637

## Description

### Field of the Invention

The present invention relates to a double-side polishing apparatus suitable when being used for polishing a work made of a high-hardness material such as SiC, and to a polishing method.

### Description of the Related Art

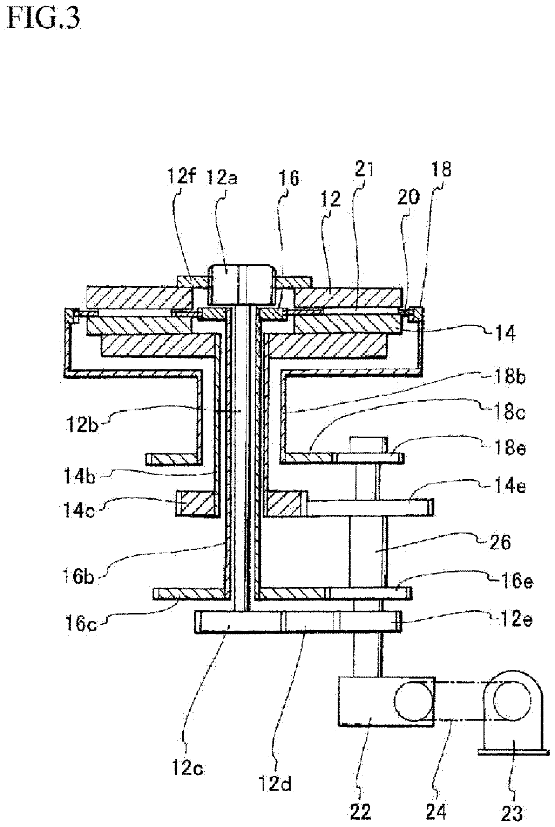

FIG. 3 is a schematic cross-sectional view showing the whole mechanism of a double-side polishing apparatus of a conventional so-called four-way drive system (lapping machine) according to the preamble of appended claim 1 as disclosed in JP H10 230452 A (Patent Literature 1).

In FIG. 3, reference numeral 12 is an upper surface plate, 14 is a lower surface plate, 16 is a sun gear, and 18 is an internal gear. Reference numeral 20 is a carrier that is positioned between the upper surface plate 12 and the lower surface plate 14, meshes with the sun gear 16 and the internal gear 18, and rotates on its axis and revolves around the sun gear 16. A work 21 such as a silicon wafer is held in a through-hole that is provided at the carrier 20.

The upper surface plate 12 is vertically movably supported on the upper side of the lower surface plate 14 by a not shown lifting device such as a crane mechanism. When the upper surface plate 12 descends on the lower surface plate 14, the upper surface plate 12 engages with a lathe dog (a driving drum having a key groove formed at the outer circumference) 12a via a hook 12f, and is rotated around a rotary shaft 12b by the rotation of the lathe dog 12a. The rotary shaft 12b hangs downward from the lathe dog 12a, and a gear 12c is provided at the lower end of the rotary shaft 12b. The gear 12c meshes with a driving gear 12e via an idle gear 12d. The driving gear 12e is fixed to a spindle 26. Accordingly, the upper surface plate 12 rotates via the lathe dog 12a by the rotation of the spindle 26.

The sun gear 16 is fixed to the upper end of a cylindrical rotary shaft 16b through which the rotary shaft 12b is inserted. A gear 16c fixed to the lower end of the rotary shaft 16b meshes with a driving gear 16e fixed to the spindle 26. Therefore, the sun gear 16 rotates by the rotation of the spindle 26. The lower surface plate 14 is fixed to the upper end of a cylindrical rotary shaft 14b through which the cylindrical rotary shaft 16b is inserted. A gear 14c fixed to the lower end of the rotary shaft 14b meshes with a driving gear 14e fixed to the spindle 26. Accordingly, the lower surface plate 14 rotates by the rotation of the spindle 26. The internal gear 18 is fixed to the upper end of a cylindrical rotary shaft 18b through which the cylindrical rotary shaft 14b is inserted. A gear 18c fixed to the lower end of the rotary shaft 18b meshes with a driving gear 18e fixed to the spindle 26. Accordingly, the internal gear 18 rotates by the rotation of the spindle 26. The spindle 26 is connected to a variable reduction gear 22. The variable reduction gear 22 is connected to a motor 23 via a belt 24.

Accordingly, in the conventional double-side polishing apparatus of a four-way drive system, the motor 23 is drived to rotate the upper surface plate 12 via the rotary shaft 12b and the lathe dog 12a, to rotate the lower surface plate 14 via the rotary shaft 14b, to rotate the sun gear 16 via the rotary shaft 16b, and to rotate the internal gear 18 via the rotary shaft 18b, and to thereby rotate the carrier 20, with the result that the work 21 held by the carrier 20 is polished.

### Citation List

### Patent Literature

[Patent Literature 1] Japanese laid-Open Patent Publication No. 10-230452

### SUMMARY OF THE INVENTION

### Technical Problem

As described above, in the conventional double-side polishing apparatus of a four-way drive system (four-shaft structure), upper and lower surface plates 12 and 14, the sun gear 16 and the internal gear 18 are driven all together by the drive of the motor 23, the carrier 20 is rotated, and the polishing of the work 21 can be performed.

Incidentally, in the rotation system of the upper and lower surface plates 12 and 14, the sun gear 16 and the internal gear 18, the upper and lower surface plates 12 and 14 are required to have rigidity, and inevitably, have large weight, and thus a very large load is applied in the rotational driving thereof.

However, in the above-described double-side polishing apparatus of a four-way drive system, since the lathe dog 12a that rotates the upper surface plate 12 is positioned at the uppermost portion, the apparatus is forced to have a configuration in which, among four rotary shafts 12b, 14b, 16b and 18b having a coaxial structure, the rotary shaft 12b rotating the lathe dog 12a, namely, the upper surface plate 12, is disposed on the most inner side (the center of the four-shaft structure).

A rotary shaft being thick and having large rigidity is desired to be used as the rotary shaft 12b of the upper surface plate 12 which has large weight and to which a large load is applied in order to carry out the rotation thereof. However, when the rotary shaft 12b is made thick, there is such disadvantage that the whole apparatus having a four-shaft structure is inevitably upsized.

In particular, nowadays, as a work to be polished, works of a high-hardness material (a hard-to-process material) such as sapphire, SiC or GaN, in addition to comparatively fragile silicon, increase. In order to polish such high-hardness materials, a further higher load to a work from the upper surface plate 12 is necessary and further higher rotation of the upper surface plate 12 is required, and thus a problem of insufficient rigidity of the conventional double-side polishing apparatus having a four-shaft structure becomes remarkable.

The present invention has been made in order to solve the above-described problem, and an object thereof is to provide a double-side polishing apparatus having high rigidity and high strength, which can also carry out good polishing of a high-hardness material, and a polishing method.

### Solution to Problem

The above- described object is achieved with the double- side polishing apparatus of the present invention and the method
of use of this double- side polishing apparatus as defined by the appended claims 1 and 6 respectively.
Advantageous further embodiments are defined in the dependent claims.

Advantageous Effects of the Invention

According to the present invention, it is possible to provide a double-side polishing apparatus having high rigidity and high strength, which can also favorably carry out polishing of high-hardness materials.

### BRIEF DESCRIPTION OF THE DRAWINGS

FIG. 1 is a cross-sectional view showing an outline of a double-side polishing apparatus according to the embodiment.
FIG. 2 is a cross-sectional view of a principal part of the double-side polishing apparatus according to the embodiment.
FIG. 3 is an explanatory view showing a schematic configuration of a conventional double-side polishing apparatus.

### DESCRIPTION OF THE EMBODIMENTS

Hereinafter, suitable embodiments of the present invention will be explained in detail on the basis of attached drawings.

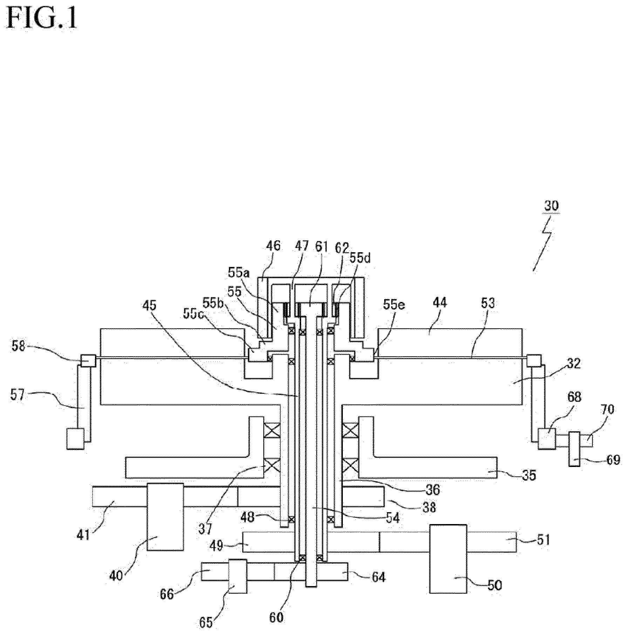

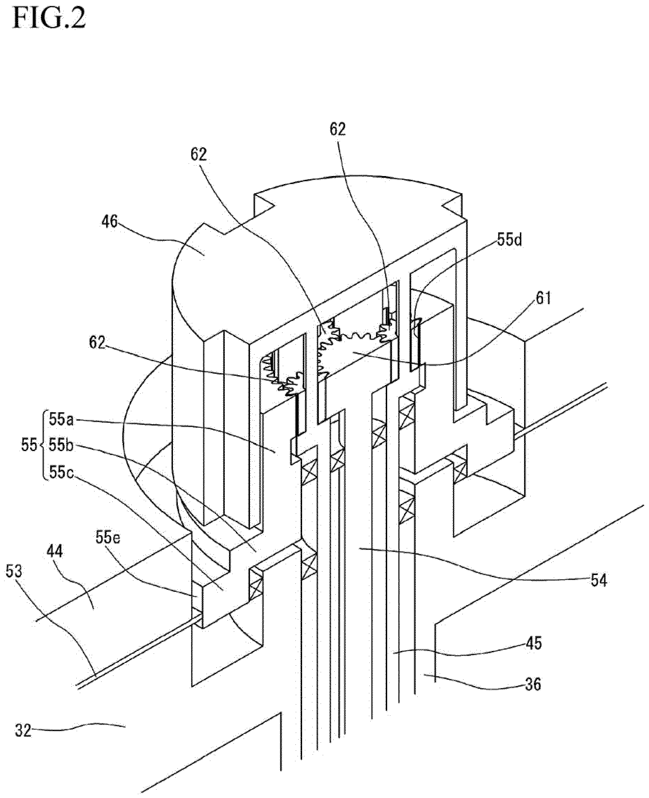

FIG. 1 is a cross-sectional view (hatching is omitted) showing the outline of a double-side polishing apparatus 30, and FIG. 2 is a cross-sectional view showing a principal part thereof.

Reference numeral 32 is a lower surface plate that has a broad ring-like shape, and the upper surface thereof is set to be a polishing surface. The lower surface plate 32 is placed on a surface plate reception part (not shown). The lower surface plate 32 and the surface plate reception part are disposed rotatably around a cylindrical third rotary shaft 36 on a base 35 via a bearing (not shown). Reference numeral 37 is a bearing of the rotary shaft 36.

A gear 38 is fixed to the lower end of the third rotary shaft 36, and meshes with a gear 41 fixed to a rotary shaft 40 of a drive motor (not shown). Accordingly, the lower surface plate 32 is rotated in a prescribed direction when the drive motor is driven. A lower surface plate rotation driving mechanism is constituted of the drive motor, the third rotary shaft 36, the gear 38, the gear 41 and the like.

Reference numeral 44 is an upper surface plate having a broad ring-like shape, and the lower surface thereof is set to be a polishing surface. The upper surface plate 44 is provided facing the lower surface plate 32, on the upper side of the lower surface plate 32, and is provided so as to enable free up-and-down motion by a vertical driving unit that is not shown and to be rotatable around the first rotary shaft 45.

The first rotary shaft 45 has a cylindrical shape, and is inserted rotatably through the central hole of the lower surface plate 32 and the third rotary shaft 36 and extends vertically, and a lathe dog 46 is fixed to the upper end thereof, via a connecting part 47. The lathe dog 46 is a driving drum with a key groove formed on the outer circumference extending vertically, and a hook part (not shown) engages with the key groove of the lathe dog 46 when the upper surface plate 44 is caused to descend by a lifting device. The first rotary shaft 45 is rotatably supported by the third rotary shaft 36 via a bearing 48.

A gear 49 is fixed to the lower end of the first rotary shaft 45, and the gear 49 meshes with a gear 51 fixed to a rotary shaft 50 of a drive motor (not shown). Accordingly, a configuration is such that, when the drive motor is driven, the upper surface plate 44 is rotated in a direction opposite to the lower surface plate 32 via the lathe dog 46. An upper surface plate rotation driving mechanism is constituted of the drive motor, the first rotary shaft 45, the gear 49, the gear 51, the lathe dog 46 and the like.

Reference numeral 53 is a carrier, which is disposed between the lower surface plate 32 and the upper surface plate 44. The carrier 53 has a through-hole (not shown) that holds a work.

A gear is formed at the outer circumference of the carrier 53, and the gear meshes with a sun gear 55 that is disposed in a central hole of the lower surface plate 32 and rotates around a second rotary shaft 54, and with an internal gear 58 that is disposed surrounding the lower surface plate 32 and rotates around a fourth rotary shaft 57.

The sun gear 55 is formed into a shape of cylinder having three-level diameter parts of a small-diameter part 55a, a middle-diameter part 55b and a large-diameter part 55c from the top, and is rotatably supported on the upper outside of the first rotary shaft 45 for driving the upper surface plate, via a bearing. An internal tooth 55d is formed on the inner circumference of the small-diameter part 55a of the sun gear 55, and an external tooth 55e that meshes with the carrier 53 is formed on the outer circumference of the large-diameter part 55c.

The lathe dog 46 that transmits turning force to the upper surface plate 44 is formed into a crown-like shape opened downward, and the small-diameter part 55a of the sun gear 55 enters an inside of the lathe dog 46. Accordingly, the total height thereof can be suppressed low because of the relationship between the sun gear 55 and the lathe dog 46.

The second rotary shaft 54 rotating the sun gear 55 is rotatably inserted through the first rotary shaft 45 in a cylindrical shape for driving the upper surface plate via a bearing 60, and extends vertically. A pinion gear 61 is fixed to the upper end of the second rotary shaft 54.

A void part is formed at the upper part of the first rotary shaft 45 for driving the upper surface plate. Furthermore, four (in FIG. 2, only three are shown) planetary gears 62 are disposed in the void part.

The planetary gear 62 meshes with the pinion gear 61 and the internal tooth 55d of the sun gear 55, and transmits the rotation of the second rotary shaft 54 for driving the sun gear to the sun gear 55.

A gear 64 is fixed to the lower end of the second rotary shaft 54, and the gear 64 meshes with a gear 66 fixed to a rotary shaft 65 of a drive motor (not shown). A driving mechanism of the second rotary shaft 54 is constituted of the gear 64, the gear 66, the drive motor, and the like. Accordingly, when the drive motor is driven, the sun gear 55 is rotated in a prescribed direction, via the pinion gear 61 and the planetary gear 62. A sun gear rotation driving mechanism is constituted of the drive motor, the gear 64, the gear 66, the second rotary shaft 54, the planetary gear 62, and the like.

In the embodiment, the connecting part 47 that fixes the lathe dog 46 to the upper end of the first rotary shaft 45 is formed to the rotary shaft of the planetary gear 62. A space between these rotary shafts is the void part. Note that the planetary gear 62 may simply be disposed in the void part, instead of using the connecting part 47 as a rotary shaft.

The internal gear 58 rotates in a prescribed direction around the fourth rotary shaft 57 as described above.

A gear 68 is fixed to the lower end of the fourth rotary shaft, and the gear 68 meshes with a gear 70 fixed to a rotary shaft 69 of a drive motor (not shown). An internal gear rotation driving mechanism is constituted of the drive motor, the gear 68, the gear 70 and the like.

Furthermore, a carrier rotation driving mechanism is constituted of the sun gear rotation driving mechanism, the internal gear rotation driving mechanism, the sun gear 55 and the internal gear 58.

The double-side polishing apparatus 30 according to the embodiment is constituted as described above.

The lower surface plate 32 is rotated by the rotation of the third rotary shaft 36, and the upper surface plate 44 is rotated by the rotation of the first rotary shaft 45. In addition, the sun gear 55 is rotated via the pinion gear 61 and the planetary gear 62, by the rotation of the second rotary shaft 54, and furthermore, the internal gear 58 is rotated by the rotation of the fourth rotary shaft 57, with the result that the carrier 53 is rotated. Accordingly, a work held in the through-hole of the carrier 53 is polished with upper and lower surface plates 32 and 44.

Note that slurry (polishing liquid) is supplied by a slurry supply mechanism, between upper and lower surface plates 32 and 44.

Note that, furthermore, in the double-side polishing apparatus 30 according to the embodiment, when the upper surface plate 44 is rotated, the rotation of the upper surface plate 44 exerts an influence on the rotation of the sun gear 55 since the connecting part 47 that connects the first rotary shaft 45 thereof and the lathe dog 46 serves as a rotary shaft of the planetary gear 62. When setting a rotation number of the sun gear 55, it is necessary to set a number of teeth of a group of gears and a rotation number of a drive motor in consideration of the influence of the rotation from the upper surface plate 44. Basically, the rotation number of the sun gear 55 is determined by a combination of the rotation number of the second rotary shaft 54 and the rotation number of the first rotary shaft 45.

Note that maintenance occasions due to abrasion can be reduced by adding a mechanism that moves the sun gear 55 up and down (not shown) and using the mechanism while appropriately changing vertically a mesh position of the gear.

As described above, in the embodiment, the second rotary shaft 54 that rotates the sun gear 55 is disposed at the center, and the first rotary shaft 45 that rotationally drives the upper surface plate 44 is provided in a large-diameter cylindrical shape, outside the second rotary shaft 54. Accordingly, the first rotary shaft 45 for driving the upper surface plate 44, to which a large load is applied, can be formed into one that is thick and has high rigidity. Therefore, it has also become possible to satisfactorily perform polishing of a work of a high-hardness material such as sapphire, SiC or GaN. Note that, in terms of a shaft structure, only dispositions of the first rotary shaft 45 for driving the upper surface plate 44 and the second rotary shaft 54 for driving the sun gear 55 are mutually changed, and thus an increase in size of the whole apparatus is not caused.

Furthermore, the embodiment forms, as described above, a three-shaft structure in which the third rotary shaft 36 of the lower surface plate 32 is formed into a cylindrical shape, the cylindrical first rotary shaft 45 for driving the upper surface plate 44 is rotatably inserted through the third rotary shaft 36 of the lower surface plate 32, and the second rotary shaft 54 for driving the sun gear 55 is inserted through the cylindrical first rotary shaft 45. On the other hand, the fourth rotary shaft 57 of the internal gear 58 is borne differently apart from the rotary shaft having the above-described three-shaft structure.

In addition, the third rotary shaft 36 of the lower surface plate 32, the first rotary shaft 45 for driving the upper surface plate 44, and the second rotary shaft 54 for driving the sun gear 55 are respectively connected to a drive motor via a group of gears 38 and 41, a group of gears 49 and 51 and a group of gears 64 and 66, and the groups of gears are vertically overlapped with one another. In contrast, the fourth rotary shaft 57 rotating the internal gear 58 is provided, as described above, differently from the rotary shaft having a three-shaft structure, and a group of gears 68 and 70 thereof is not vertically overlapped with the group of gears connecting the rotary shaft having the above-described three-shaft structure to the drive motor, and is disposed within a different space. Accordingly, the height of the base 35 rotating and supporting the lower surface plate 32 can be lowered, and, eventually, the total height of the double-side polishing apparatus 30 can be lowered. For example, the height of the upper surface of the lower surface plate (operation position) in a conventional apparatus is about 1100 mm from a floor face, whereas, in the embodiment, the height is 950 mm, namely, the height can be lowered to as low as 10% or more as compared with in the conventional apparatus, and, as the result, reduction in the length of the rotary shaft and lowering of the center of gravity can be achieved. In this way, there are exerted the effects of being able to stabilize the apparatus, to reduce generation of vibration caused by polishing resistance of a work, and to accurately polish a work, by making it possible to set the height of the double-side polishing apparatus 30 to be low.

## Claims

1. A double-side polishing apparatus (30), comprising: a lower surface plate (32) in a ring-like shape, which has an upper surface formed into a polishing surface, and which is supported on a base (35); an upper surface plate (44) which has a lower surface formed into a polishing surface, and which is provided vertically movably and rotatably around a first rotary shaft (45), above the lower surface plate (32); a carrier (53) which is disposed between the lower surface plate (32) and the upper surface plate (44) and which has a through-hole that holds a work; an upper surface plate rotation driving mechanism that includes a lathe dog (46) which is fixed to the first rotary shaft (45) and with which the upper surface plate (44) is engaged in a free up-and-down motion, and that rotationally drives the upper surface plate (44); wherein the first rotary shaft (45) rotating the upper surface plate (44) has a cylindrical shape, is rotatably inserted in a central hole of the lower surface plate (32) and extends vertically, and has the lathe dog (46) fixed to an upper end thereof;
the double-side polishing apparatus further comprising:
carrier rotation driving mechanism that includes a sun gear (55) which is disposed in a central hole of the lower surface plate (32), which meshes with the carrier (53) and rotates around a second rotary shaft (54), and an internal gear (58) which is disposed around the lower surface plate (32) and meshes with the carrier (53), and that causes the carrier (53) to revolve around the sun gear (55) while rotating the carrier (53) on its axis; and a driving mechanism that rotationally drives the second rotary shaft (54),
the double-side polishing apparatus being **characterized in that**;
the second rotary shaft (54) rotating the sun gear (55) is rotatably inserted through the first rotary shaft (45), which has a cylindrical shape, is used for driving the upper surface plate (44) and extends vertically, and the second rotary shaft (54) has a pinion gear (61) fixed to an upper end thereof;
the sun gear (55) has a cylindrical shape and is rotatably supported outside an upper end part of the first rotary shaft (45) used for driving the upper surface plate (44), and the sun gear (55) has an internal tooth (55d) formed on an inner circumference part and an external tooth (55e) that meshes with the carrier (53), formed on an outer circumference part; and
a void part is formed at an upper part of the first rotary shaft (45) for driving the upper surface plate (44), and in the void part, a planetary gear (62) which meshes with the pinion gear (61) being provided on the second rotary shaft (54) and the internal tooth (55d) of the sun gear (55) and which transmits rotation of the second rotary shaft (54) rotated by the driving mechanism to the sun gear (55), is disposed.

2. The double-side polishing apparatus (30) according to claim 1, wherein
the lathe dog (46) has a crown-like shape opened downward, an upper part of the sun gear (55) having a cylindrical shape enters an inside of the lathe dog (46), and the external tooth (55e) provided on an outer circumference part is exposed.

3. The double-side polishing apparatus (30) according to claim 1 or 2, wherein
a connecting part (47) that connects the first rotary shaft (45) and the lathe dog (46) is provided at an upper end part of the first rotary shaft (45) for driving the upper surface plate (44), and the connecting part (47) serves as a rotary shaft of the planetary gear (62).

4. The double-side polishing apparatus (30) according to any one of claims 1 to 3, wherein:
the lower surface plate (32) is disposed, on the base (35), rotatably around a third rotary shaft (36) by a lower surface plate rotation driving mechanism;
the internal gear (58) is disposed rotatably around a fourth rotary shaft (57) by an internal gear rotation driving mechanism;
the third rotary shaft (36) of the lower surface plate (32) has a cylindrical shape, and the cylindrical first rotary shaft (45) for driving the upper surface plate (44) is rotatably inserted through the third rotary shaft (36) of the lower surface plate (32);
the third rotary shaft (36) of the lower surface plate (32), the first rotary shaft (45) for driving the upper surface plate (44), and the second rotary shaft (54) for driving the sun gear (55) are formed into a three-shaft structure that are mutually borne; and the fourth rotary shaft (57) of the internal gear (58) is borne differently apart from the rotary shaft having the three-shaft structure.

5. The double-side polishing apparatus (30) according to claim 4, wherein
the third rotary shaft (36) of the lower surface plate (32), the first rotary shaft (45) for driving the upper surface plate (44) and the second rotary shaft (54) for driving the sun gear (55) are respectively connected to a drive motor via groups of gears, and the groups of gears are vertically overlapped.

6. A polishing method of a work that is held by the carrier (53), by using a double-side polishing apparatus (30) according to claim 1, the method comprising the steps of;
rotating the first rotary shaft (45) by the upper surface plate rotation driving mechanism to thereby rotate the upper surface plate (44) at a prescribed rotation number; and
rotating the second rotary shaft (54) by a driving mechanism, and rotating the sun gear (55) at a rotation number determined by a combination of a rotation number of the first rotary shaft (45) and a rotation number of the second rotary shaft (54), via a pinion gear (61) that is provided on the second rotary shaft (54) and a planetary gear (62) that is rotatably supported by the first rotary shaft (45) and that meshes with the pinion gear (61) and an internal tooth (55d) being provided on the sun gear (55), to thereby cause the carrier (53) to revolve around the sun gear (55) while rotating the carrier (53) on its axis.

7. The polishing method according to claim 6, wherein, in the double-side polishing apparatus (30):
the lower surface plate (32) is disposed on the base (35), rotatably around a third rotary shaft (36) by a lower surface plate rotation driving mechanism; and
the internal gear (58) is disposed rotatably around a fourth rotary shaft (57) by an internal gear rotation driving mechanism.

## Patentansprüche

1. Doppelseitige Poliervorrichtung (30), umfassend: eine untere Oberflächenplatte (32) in Ringform, die eine zu einer Polieroberfläche ausgebildete, obere Oberfläche aufweist, und die auf einer Basis (35) gelagert ist; eine obere Oberflächenplatte (44), die eine zu einer Polieroberfläche ausgebildete, untere Oberfläche aufweist, und die oberhalb der unteren Oberflächenplatte (32) um eine erste Drehwelle (45) vertikal bewegbar und drehbar bereitgestellt ist; einen Träger (53), der zwischen der unteren Oberflächenplatte (32) und der oberen Oberflächenplatte (44) angeordnet ist, und der ein ein Werkstück haltendes Durchgangsloch aufweist; einen Rotationsantriebsmechanismus für die obere Oberflächenplatte, der ein Drehherz (46) umfasst, das an der ersten Drehwelle (45) befestigt ist, und mittels dessen die obere Oberflächenplatte (44) in einer freien Auf- und-Ab-Bewegung in Eingriff ist, und das die obere Oberflächenplatte (44) rotierend antreibt;
worin die erste Drehwelle (45), welche die obere Oberflächenplatte (44) dreht, eine zylindrische Form aufweist, drehbar in ein Mittelloch der unteren Oberflächenplatte (32) eingebracht ist und sich vertikal erstreckt, und das Drehherz (46) an einem oberen Ende derselben befestigt aufweist;
wobei die doppelseitige Poliervorrichtung ferner Folgendes umfasst:
einen Trägerrotationsantriebsmechanismus, der ein Sonnenrad (55), das in einem Mittelloch der unteren Oberflächenplatte (32) angeordnet ist, das mit dem Träger (53) in kämmendem Eingriff ist und sich um eine zweite Drehwelle (54) dreht, und ein Innenrad (58) umfasst, das um die untere Oberflächenplatte (32) herum angeordnet ist und mit dem Träger (53) in kämmendem Eingriff ist, und das bewirkt, dass sich der Träger (53) bei gleichzeitigem Drehen des Trägers (53) um seine Achse um das Sonnenrad (55) herum dreht; und einen Antriebsmechanismus, der die zweite Drehwelle (54) rotierend antreibt,
wobei die doppelseitige Poliervorrichtung **dadurch gekennzeichnet ist, dass**
die zweite Drehwelle (54), die das Sonnenrad (55) dreht, drehbar durch die erste Drehwelle (45), die eine zylindrische Form aufweist, eingebracht ist, die zum Antreiben der oberen Oberflächenplatte (44) verwendet wird und sich vertikal erstreckt, und die zweite Drehwelle (54) ein Ritzelzahnrad (61) aufweist, das am oberen Ende derselben befestigt ist;
dass das Sonnenrad (55) eine zylindrische Form aufweist und drehbar außerhalb eines oberen Endabschnitts der ersten Drehwelle (45), die zum Antreiben der oberen Oberflächenplatte (44) verwendet wird, gelagert ist,
und dass das Sonnenrad (55) eine auf einem Innenumfangsabschnitt ausgebildete Innenverzahnung (55d) und eine auf dem Außenumfangsabschnitt ausgebildete Außenverzahnung (55e), die mit dem Träger (35) in Eingriff ist, aufweist; und
ein Hohlraumabschnitt in einem oberen Teil der ersten Drehwelle (45) zum Antreiben der oberen Oberflächenplatte (44) ausgebildet ist, und im Hohlraumabschnitt ein Planetenrad (62) angeordnet ist, das mit dem auf der zweiten Drehwelle (54) bereitgestellten Ritzelrad (61) und der Innenverzahnung (55d) des Sonnenrads (55) in kämmendem Eingriff ist, und das die Rotation der zweiten Drehwelle (54), die durch den Antriebsmechanismus gedreht wird, auf das Sonnenrad (55) überträgt.

2. Doppelseitige Poliervorrichtung (30) gemäß Anspruch 1, worin
das Drehherz (46) eine nach unten geöffnete kronenartige Form aufweist, ein oberer Teil des Sonnenrads (55), der eine zylindrische Form aufweist, in eine Innenseite des Drehherzes (46) eintritt, und die auf einem Außenumfangsabschnitt bereitgestellte Außenverzahnung (55e) freigelegt ist.

3. Doppelseitige Poliervorrichtung (30) gemäß Anspruch 1 oder 2, worin
ein Verbindungsteil (46), der die erste Drehwelle (45) und das Drehherz (46) verbindet, an einem oberen Endabschnitt der ersten Drehwelle (45) zum Antreiben der oberen Oberflächenplatte (44) bereitgestellt ist, und der Verbindungsteil (47) als eine Drehwelle des Planetenrades (62) dient.

4. Doppelseitige Poliervorrichtung (30) gemäß einem der Ansprüche 1 bis 3, worin:
die untere Oberflächenplatte (32) auf der Basis (35) drehbar um eine dritte Drehwelle (36) durch einen Rotationsantriebsmechanismus für die untere Oberflächenplatte angeordnet ist;
das Innenrad (58) durch einen Innenradrotationsantriebsmechanismus drehbar um eine vierte Drehwelle (57) angeordnet ist;
die dritte Drehwelle (36) der unteren Oberflächenplatte (32) eine zylindrische Form aufweist, und die zylindrische erste Drehwelle (45) zum Antreiben der oberen Oberflächenplatte (44) durch die dritte Drehwelle (36) der unteren Oberflächenplatte (32) drehbar eingebracht ist;
die dritte Drehwelle (36) der unteren Oberflächenplatte (32), die erste Drehwelle (45) zum Antreiben der oberen Oberflächenplatte (44) und die zweite Drehwelle (54) zum Antreiben des Sonnenrades (55) zu einer Drei-Wellen-Struktur ausgebildet sind, die sich gegenseitig lagern; und die vierte Drehwelle (57) des Innenrades (58) von der die Drei-Wellen-Struktur aufweisenden Drehwelle unterschiedlich gelagert angeordnet ist.

5. Doppelseitige Poliervorrichtung (30) gemäß Anspruch 4, worin
die dritte Drehwelle (36) der unteren Oberflächenplatte (32), die erste Drehwelle (45) zum Antreiben der oberen Oberflächenplatte (44) und die zweite Drehwelle (54) zum Antreiben des Sonnenrades (55) über Zahnrädergruppen jeweils mit einem Antriebsmotor verbunden sind, und die Zahnrädergruppen vertikal überlappt sind.

6. Polierverfahren eines Werkstücks, das durch den Träger (53) gehalten ist, unter Anwendung einer doppelseitigen Poliervorrichtung (30) gemäß Anspruch 1, wobei das Verfahren die folgenden Schritte umfasst:
Drehen der ersten Drehwelle (45) durch den Rotationsantriebsmechanismus für die obere Oberflächenplatte, um dadurch die obere Oberflächenplatte (44) bei einer vorgeschriebenen Rotationszahl zu drehen, und
Drehen der zweiten Drehwelle (54) durch einen Antriebsmechanismus, und Drehen des Sonnenrades (55) bei einer Rotationszahl, die durch eine Kombination einer Rotationszahl der ersten Drehwelle (45) und einer Rotationszahl der zweiten Drehwelle (54) über ein Ritzelzahnrad (61) bereitgestellt ist, bestimmt wird, das auf der zweiten Drehwelle (54) und einem Planetenrad (62), das durch die erste Drehwelle (45) drehbar gelagert ist und das mit dem Ritzelzahnrad und einer auf dem Sonnenrad (55) bereitgestellten Innenverzahnung (55d) in Eingriff ist, um dadurch zu bewirken, dass sich der Träger (53) um das Sonnenrad (55) bei gleichzeitigem Drehen des Trägers (53) auf dessen Achse dreht.

7. Polierverfahren gemäß Anspruch 6, worin in der doppelseitigen Poliervorrichtung (30)
die untere Oberflächenplatte (32) auf der Basis drehbar um eine dritte Drehwelle (36) durch einen Rotationsantriebsmechanismus für die untere Oberflächenplatte angeordnet ist, und
das Innenrad (58) durch einen Innenradrotationsantriebsmechanismus drehbar um eine vierte Drehwelle (57) angeordnet ist.

## Revendications

1. Appareil de polissage double face (30), comprenant: une plaque de surface inférieure (32) en forme d'anneau, qui possède une surface supérieure formée en une surface de polissage, et qui est supportée sur une base (35) ; une plaque de surface supérieure (44) qui possède une surface inférieure formée en une surface de polissage, et qui est prévue de manière verticalement mobile et rotative autour d'un premier arbre rotatif (45) au-dessus de la plaque de surface inférieure (32) ; un support (53) qui est disposé entre la plaque de surface inférieure (32) et la plaque de surface supérieure (44) et qui possède un orifice traversant qui maintient une pièce ; un mécanisme d'entraînement de rotation de plaque de surface supérieure qui comprend un toc (46) qui est fixé sur le premier arbre rotatif (45) et avec lequel la plaque de surface supérieure (44) est engagée selon un mouvement ascendant et descendant libre, et qui entraîne par rotation la plaque de surface supérieure (44) ; dans lequel le premier arbre rotatif (45) qui fait tourner la plaque de surface supérieure (44) possède une forme cylindrique, est inséré de manière rotative dans un orifice central de la plaque de surface inférieure (32) et s'étend verticalement, et possède le toc (46) fixé sur une extrémité supérieure de celui-ci ;
l'appareil de polissage double face comprenant en outre :
un mécanisme d'entraînement de rotation de support qui comprend un planétaire (55) qui est disposé dans un orifice central de la plaque de surface inférieure (32), qui s'engrène avec le support (53) et qui tourne autour d'un second arbre rotatif (54), et un engrenage interne (58) qui est disposé autour de la plaque de surface inférieure (32) et s'engrène avec le support (53), et qui permet au support (53) de tourner autour du planétaire (55) tout en faisant tourner le support (53) sur son axe ; et un mécanisme d'entraînement qui entraîne par rotation le second arbre rotatif (54),
l'appareil de polissage double face étant **caractérisé en ce que** :
le second arbre rotatif (54) qui fait tourner le planétaire (55) est inséré de manière rotative dans le premier arbre rotatif (45), qui possède une forme cylindrique, est utilisé pour entraîner la plaque de surface supérieure (44) et s'étend à la verticale, et le second arbre rotatif (54) possède un engrenage à pignons (61) fixé sur une extrémité supérieure de celui-ci ;
le planétaire (55) possède une forme cylindrique et est supporté de manière rotative à l'extérieur d'une partie d'extrémité supérieure du premier arbre rotatif (45) utilisé pour entraîner la plaque de surface supérieure (44), et le planétaire (55) possède une dent interne (55d) formée sur une partie de circonférence interne et une dent externe (55e) qui s'engrène avec le support (53), formée sur une partie de circonférence externe ; et
une partie de vide est formée au niveau d'une partie supérieure du premier arbre rotatif (45) pour entraîner la plaque de surface supérieure (44), et, dans la partie de vide, est disposé un engrenage planétaire (62) qui s'engrène avec l'engrenage à pignons (61) prévu sur le second arbre rotatif (54) et la dent interne (55d) du planétaire (55) et qui transmet la rotation du second arbre rotatif (54) tourné par le mécanisme d'entraînement au planétaire (55).

2. Appareil de polissage double face (30) selon la revendication 1, dans lequel
le toc (46) possède une forme de couronne ouverte vers le bas, une partie supérieure du planétaire (55) qui possède une forme cylindrique pénètre à l'intérieur du toc (46), et la dent externe (55e) prévue sur une partie de circonférence externe est exposée.

3. Appareil de polissage double face (30) selon la revendication 1 ou 2, dans lequel
une partie de liaison (47) qui relie le premier arbre rotatif (45) et le toc (46) est prévue au niveau d'une partie d'extrémité supérieure du premier arbre rotatif (45) pour entraîner la plaque de surface supérieure (44), et la partie de liaison (47) sert d'arbre rotatif de l'engrenage planétaire (62).

4. Appareil de polissage double face (30) selon l'une quelconque des revendications 1 à 3, dans lequel :
la plaque de surface inférieure (32) est disposée, sur la base (35), de manière rotative autour d'un troisième arbre rotatif (36) par un mécanisme d'entraînement de rotation de plaque de surface inférieure ;
l'engrenage interne (58) est disposé de manière rotative autour d'un quatrième arbre rotatif (57) par un mécanisme d'entraînement de rotation d'engrenage interne ;
le troisième arbre rotatif (36) de la plaque de surface inférieure (32) possède une forme cylindrique, et le premier arbre rotatif cylindrique (45) destiné à entraîner la plaque de surface supérieure (44) est inséré de manière rotative dans le troisième arbre rotatif (36) de la plaque de surface inférieure (32) ;
le troisième arbre rotatif (36) de la plaque de surface inférieure (32), le premier arbre rotatif (45) destiné à entraîner la plaque de surface supérieure (44), et le second arbre rotatif (54) destiné à entraîner le planétaire (55) sont formés en une structure à trois arbres qui sont mutuellement supportés ; et
le quatrième arbre rotatif (57) de l'engrenage interne (58) est supporté différemment à part de l'arbre rotatif qui possède la structure à trois arbres.

5. Appareil de polissage double face (30) selon la revendication 4, dans lequel
le troisième arbre rotatif (36) de la plaque de surface inférieure (32), le premier arbre rotatif (45) destiné à entraîner la plaque de surface supérieure (44) et le second arbre rotatif (54) destiné à entraîner le planétaire (55) sont respectivement reliés à un moteur d'entraînement à l'aide de groupes d'engrenages, et les groupes d'engrenages sont verticalement chevauchés.

6. Procédé de polissage d'une pièce qui est maintenue par le support (53), à l'aide d'un appareil de polissage double face (30) selon la revendication 1, le procédé comprenant les étapes de :
rotation du premier arbre rotatif (45) par le mécanisme d'entraînement de rotation de plaque de surface supérieure afin de faire tourner la plaque de surface supérieure (44) selon un nombre de rotations prescrit ; et
de rotation du second arbre rotatif (54) par un mécanisme d'entraînement, et de rotation du planétaire (55) selon un nombre de rotations déterminé par une combinaison d'un nombre de rotations du premier arbre rotatif (45) et d'un nombre de rotations du second arbre rotatif (54), par le biais d'un engrenage à pignons (61) qui est prévu sur le second arbre rotatif (54) et d'un engrenage planétaire (62) qui est supporté de manière rotative par le premier arbre rotatif (45) et qui s'engrène avec l'engrenage à pignons (61) et une dent interne (55d) prévue sur le planétaire (55), afin de faire tourner le support (53) autour du planétaire (55) tout en faisant tourner le support (53) sur son axe.

7. Procédé de polissage selon la revendication 6, dans lequel, dans l'appareil de polissage double face (30) :
la plaque de surface inférieure (32) est disposée sur la base (35), de manière rotative autour d'un troisième arbre rotatif (36) par un mécanisme d'entraînement de rotation de plaque de surface inférieure ; et
l'engrenage interne (58) est disposé de manière rotative autour d'un quatrième arbre rotatif (57) par un mécanisme d'entraînement de rotation d'engrenage interne.
